# EUROPEAN PATENT SPECIFICATION

(11) **EP 3 698 388 B1**
(45) Date of publication and mention of the grant of the patent: **02.12.2026**
(21) Application number: 17928956.6
(22) Date of filing: 16.10.2017
(51) Int. Cl.: G01R 31/327, H01H 11/00, H01H 33/66, H01H 33/666

(54) **METHOD FOR MONITORING CIRCUIT BREAKER AND APPARATUS AND INTERNET OF THINGS USING THE SAME**
VERFAHREN ZUR ÜBERWACHUNG EINES SCHUTZSCHALTERS UND VORRICHTUNG UND INTERNET DER DINGE MIT VERWENDUNG DAVON
PROCÉDÉ DE SURVEILLANCE DE DISJONCTEUR ET APPAREIL ET INTERNET DES OBJETS L'UTILISANT

(43) Date of publication of application: 26.08.2020
(73) Proprietor: Hitachi Energy Ltd, 8050 Zürich (CH)
(72) Inventor: CHEN, Niya, Beijing 100016 (CN); YU, Rongrong, Beijing 100123 (CN); RUAN, Jiayang, Beijing 100018 (CN)
(74) Representative: Michalski Hüttermann & Partner mbB
(86) International application number: PCT/CN2017/106364
(87) International publication number: WO 2019/075612

(56) References cited:
- EP-A1- 1 022 632
- EP-A1- 3 293 853
- WO-A1-2016/176913
- WO-A1-2017/060080
- CN-A- 101 149 420
- CN-A- 102 269 650
- CN-U- 202 650 951
- US-A1- 2002 123 864
- US-A1- 2006 006 997
- US-A1- 2016 246 185
- US-A1- 2016 299 192
- US-A1- 2017 047 186
- US-A1- 2017 194 113
- FEIZIFAR BEHNAM ET AL: "Condition monitoring of circuit breakers: Current status and future trends", 2017 IEEE INTERNATIONAL CONFERENCE ON ENVIRONMENT AND ELECTRICAL ENGINEERING AND 2017 IEEE INDUSTRIAL AND COMMERCIAL POWER SYSTEMS EUROPE (EEEIC / I&CPS EUROPE), IEEE, 6 June 2017 (2017-06-06), pages 1 - 5, XP033117980, DOI: 10.1109/EEEIC.2017.7977751

## Description

### Technical Field

The invention relates to the field of circuit breaker, and more particularly to monitoring health condition of circuit breaker.

### Background Art

Circuit breaker is one of the most critical components of a Gas Insulation Switchgear (GIS) or a substation, whose safety and reliability are of high importance to the overall power grid. The market of smart circuit breaker is increasing rapidly these years, especially with the world's growing attention on digital products. Therefore, it's desired by the market a kind of smart circuit breaker being able to real-time monitor its defects and severity thereof before evolving to real failure, namely to monitor its health condition before real failure occurring. An example is disclosed in Patent CN 105628419 A. According the above referenced patent, the GIS mechanical defect diagnosis system has an acceleration sensor fixed in a detecting point position and the GIS shell surface position. A data processing device is connected with the acceleration sensor, a charge amplifier and a data acquisition unit. The data processing device receives a vibration signal according to independent component analysis process, and determine the GIS mechanical fault type solely in consideration of the received vibration signal if it is outside of a predetermined range.

However, the solution according to the prior art patent requires comparing the operating condition related parameter measurement (for example, the acceleration measurement) with thresholds defining a linear range. Where the health status of the circuit breaker were to be judged using various operating condition related parameters, for example opening/closing speed of a movable contact of the circuit breaker, travel of the movable contact, total travel of the movable contact, over travel of the movable contact, rebound of the movable contact, opening/closing time of the circuit breaker, and opening/closing peak coil electric current of the circuit breaker, most of the conventional solutions would have required individually comparing the measurement of the various types of operating condition related parameters of the circuit breaker and corresponding predetermined thresholds and judging health status of the circuit breaker upon a combination of the separate results of the comparisons if they respectively fall within the range between the corresponding thresholds. Because a correlation of the various operating condition related parameters is not considered to define their respective threshold range, missed fault and false alarm give major shortcomings in monitoring the health status of the circuit breaker. As a result, the prior art solutions are not often performed on a sufficiently accurate bases to detect the healthy or faulty condition.

WO 2016/176913 A1 describes a smart multi-dimensional big data analyzing expert system for a high-voltage circuit breaker in a power grid and method for utilizing the system to monitor a circuit breaker.

EP 3293853 A1 describes a smart multi-dimensional big data analyzing expert system for a high-voltage circuit breaker in a power grid and a method for utilizing the system to monitor a circuit breaker.

US 2002/123864 A1 describes a system and method for analyzing a process collects process data within a process control plant and transmits the collected process data to a remote data processing facility.

WO 2017/060080 A1 describes a lithographic process in which a series of wafers (W(i)) are processed in different contexts.

US 2016/246185 A1 describes a lithographic process in which product units such as semiconductor wafers are subjected to lithographic patterning operations and chemical and physical processing operations.

US 2006/006997 A1 describes a multi-criteria event detection system, comprising a plurality of sensors, wherein each sensor is capable of detecting a signature characteristic of a presence of an event and providing an output indicating the same.

US 2016/299192 A1 describes a method for monitoring a circuit breaker, comprising the following steps: obtaining a characteristic force associated with an actuating mechanism of the circuit breaker over the time; and determining the time point when the closing and/or opening of the circuit breaker occurs by identifying a variation of the force.

US 2017/194113 A1 describes a failure prediction assembly which is structured to monitor circuit breaker assembly sub-assemblies and their component's characteristics.

US 2017/047186 A1 describes a monitoring latch assembly structured to monitor circuit breaker assembly operating mechanism component characteristics.

FEIZIFAR BEHNAM et al. describe "Condition monitoring of circuit breakers: Current status and future trends" in 2017 IEEE INTERNATIONAL CONFERENCE ON ENVIRONMENT AND ELECTRICAL ENGINEERING AND 2017 IEEE INDUSTRIAL AND COMMERCIAL POWER SYSTEMS EUROPE (EEEIC / I&CPS EUROPE).

### Brief Summary of the Invention

The invention is defined by the features of the independent claims.

According to an aspect of present invention, it provides a method for monitoring a circuit breaker, including: measuring at least two operating condition related parameters of the circuit breaker during operation of the circuit breaker; obtaining first data representing a vector having at least two components respectively representing the at least two measurements of the at least two parameters; judging location of the vector represented by the obtained data with respect to a vector space having an envelope separating healthy and unhealthy status of the circuit breaker, where the envelope has at least one portion of curvature; and generating a signal indicating the health status of the circuit breaker in consideration of the location of the vector if it is outside of the envelope.

According to another aspect of present invention, it provides a system for monitoring a circuit breaker, including: at least one sensor, being configured to measure at least two operating condition related parameters of the circuit breaker during operation of the circuit breaker; and a controller, being configured to: obtain first data representing a vector having at least two components respectively representing the at least two measurements of the at least two parameters; judge location of the vector represented by the obtained data with respect to a vector space having an envelope separating healthy and unhealthy status of the circuit breaker, where the envelope has at least one portion of curvature; and generate a signal indicating the health status of the circuit breaker in consideration of the location of the vector if it is outside of the envelope.

According to another aspect of present invention, it provides an internet of things, including: the system for monitoring a circuit breaker, the circuit breaker, and a server, being configured to receive the signal indicating the health status of the circuit breaker.

By cutting off the vertices of the envelope conventionally in a linear shape and supplementing with each cut-off with a curvature, the newly adapted envelope takes the form of an ellipse having at least one portion of curvature. Therefore, both of the missed fault identification and the false alarm happened in the conventional solutions may be overcome.

The controller reads the knowledge data base and past diagnosis results stored in the memory of the system, namely the history profile. From the history profile, second data are obtained representing the envelope of the vector space in consideration of a multiple of the vectors concerning the circuit breaker in healthy status according to a history profile when the circuit breaker operated normally; and the second data are stored; wherein: the envelope of the vector space is arranged to enclose the group of the multiple of vectors.

Preferably, the other portions of the envelope are shaped in curvature.

In the vector space, the envelope is shaped to link the outmost vectors of the multiple of the vectors.

Preferably, the at least two operating condition related parameters of the circuit breaker concern with any at least two of: opening/closing speed of a movable contact of the circuit breaker, travel of the movable contact, total travel of the movable contact, over travel of the movable contact, rebound of the movable contact, opening/closing time of the circuit breaker, and opening/closing peak electric current of the circuit breaker.

### Brief Description of the Drawings

The subject matter of the invention will be explained in more detail in the following text with reference to preferred exemplary embodiments which are illustrated in the drawings, in which:
FIG. 1 illustrates an exemplary circuit breaker which can be on-line monitored by the method according to an embodiment of the present invention;
FIG. 2 illustrates the force applied on the linkage mechanism of the circuit breaker as shown in FIG. 1;
FIG.3 shows a system for monitoring a circuit according to an embodiment of present invention; and
FIG. 4 and FIG. 5 respectively show healthy vector space linearly defined by two threshold ranges concerning two types of operating condition related parameters.

The reference symbols used in the drawings, and their meanings, are listed in summary form in the list of reference symbols. In principle, identical parts are provided with the same reference symbols in the figures.

### Preferred Embodiments of the Invention

In the following description, for purposes of explanation and not limitation, specific details are set forth, such as particular circuits, circuit components, interfaces, techniques, etc. in order to provide a thorough understanding of the present invention. However, it will be apparent to one skilled in the art that the present invention may be practiced in other embodiments that depart from these specific details. In other instances, detailed descriptions of well-known methods and programming procedures, devices, and circuits are omitted so not to obscure the description of the present invention with unnecessary detail.

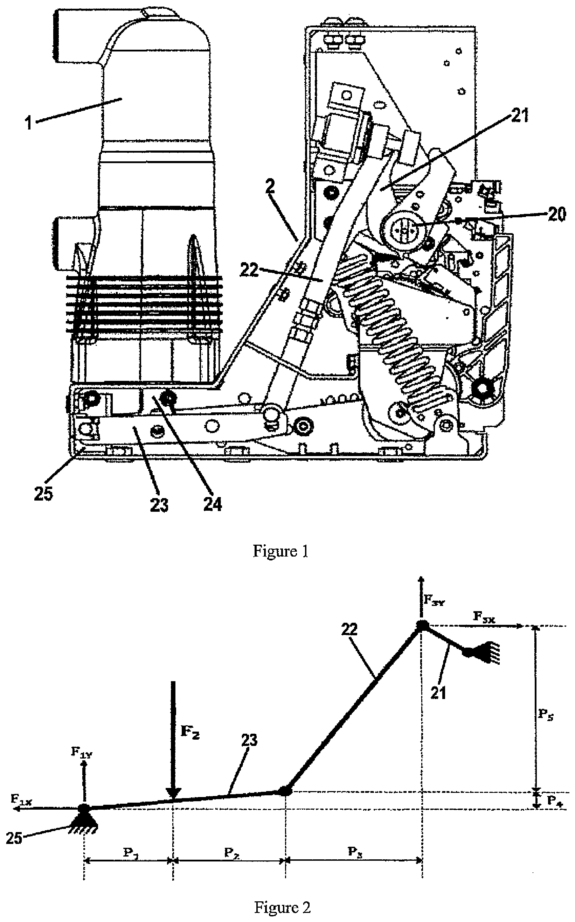

FIG. 1 illustrates an exemplary circuit breaker which can be on-line monitored by the method according to an embodiment of the present invention. The circuit breaker as shown in Fig. 1 is a vacuum circuit breaker, comprising a stationary contact and a movable contact (not shown) enclosed in an insulation pole 1, and an actuating mechanism 2 for actuating the closing and opening action of the movable contact. The actuating mechanism 2 has a plurality of elements including a linkage mechanism and a spring. The linkage mechanism is for transmitting a driving force from an active element for example, a motor or the spring actuator, to the movable contact. As shown in FIG. 1, for example, the linkage mechanism may be a four-bar linage which comprises a first lever 21, a second level 22, a third lever 23 pivotally connected to each other in sequence. The first lever 21 is connected to a driving shaft 20 driven by an active element, and the third lever 23 is pivotally connected to a fixed point 25 on the base of the circuit breaker. For example, the fixed point 25 may be one of the fulcrums of the linkage mechanism. A push rod 24 on one end is pivotally connected to the movable contact at a distance from the pivot point between the third level 23 and the fixed point 25. The other end of the push rod 24 is connected to the movable contact in the insulation pole 1. By driving the driving shaft 20 rotating via the motor 26 or the spring, the movable contact can be moved up and down in a longitudinal direction in the pole 1 by the force transmission from the first lever 21, the second level 22, the third lever 23 and the push rod 24, so as to contact or be separated from the stationary contact and thus close or open the circuit. The circuit breaker as shown in FIG. 1 may include a magnetic actuator arrangement (not shown in FIG. 1), comprising electromagnetic coil, electrical supply means for supplying the coil electric current to the coil, a latch for securing the circuit breaker's door closed capable of moving between first and second extreme positions within the magnetic actuator under influence of the coil, and electronic switch means for energising and de-energising the coil.

FIG. 2 illustrates the force applied on the linkage mechanism of the circuit breaker as shown in FIG. 1. In a balanced closed state of the circuit breaker, the movable contact abuts against the stationary contact under a force from the linkage mechanism. In this case, the stationary contact would apply a counter force F2 (also referred to as contact force) on the movable contact which is in turn conducted to the third lever 23 through the push rod 24. Once the movable contact is separated from the stationary contact in the opening period, the counter force F2 on the movable contact, the push rod 24 and the third lever 23 would decrease dramatically and even become zero. Likewise, during the closing period of the circuit breaker, the counter force F2 applied on the movable contact by the stationary contact would dramatically from zero to a relative high value.

The operating condition of the circuit breaker includes at least one of:
a. opening/closing speed of a movable contact of the circuit breaker,
b. travel of the movable contact,
c. total travel of the movable contact,
d. over travel of the movable contact,
e. rebound of the movable contact,
f. opening/closing time of the circuit breaker, and
g. opening/closing peak coil electric current of the circuit breaker.

The opening/closing speed of a movable contact of the circuit breaker is calculated between two points on the travel curve as defined by the speed calculation zone. The speed calculation zone is part of the circuit breaker type specific default settings and matches the points used for off-line timing.

The travel of the movable contact refers to the distance from where the movable starts to move until it reaches a position where the arcing contacts meet per design. This position is referred to as the "travel" and is measured from the fully closed position.

The total travel of the movable contact refers to the distance traveled from minimum to maximum position, so it includes over travel of the movable contact.

Rebound of the movable contact refers to a series of rebounds happening during the period from the first contact between movable contact and stationary contact to the eventual reliable contact established.

The timing of the opening/closing refers to the time calculated between the two points on the travel curve as defined by the speed calculation zone. The operation cycle covers a period when the circuit breaker starts from closing to opening or vice versa.

Opening/closing peak coil electric current of the circuit breaker. The circuit breaker as shown in FIG. 1 may include a magnetic actuator arrangement, comprising electromagnetic coil, electrical supply means for supplying the coil electric current to the coil, a latch for securing the circuit breaker's door closed capable of moving between first and second extreme positions within the magnetic actuator under influence of the coil, and electronic switch means for energising and de-energising the coil. A circuit breaker having the defect can still operate but will eventually develop into a failure. A defect stage occurs between normal stage and failure stage. A defect of circuit breaker results in an abnormity of those operating conditions of the circuit breaker. Accordingly, in order to improve reliability and accuracy of diagnosis of the health status of the circuit breaker, at least two of the operating conditions may be monitored. The present invention provides a highly sensitivity and highly accurate abnormality diagnosing solution using those operating condition related parameters of the circuit breaker during operation of the circuit breaker. For example, an embodiment using two of the operating condition related parameters, namely the opening/closing peak coil electric current of the circuit breaker and the opening/closing speed of a movable contact of the circuit breaker, is described thereafter for explaining the present invention. The skilled person should understand that any two or more of the operating condition related parameters may be used for diagnosis of the health condition of the circuit breaker.

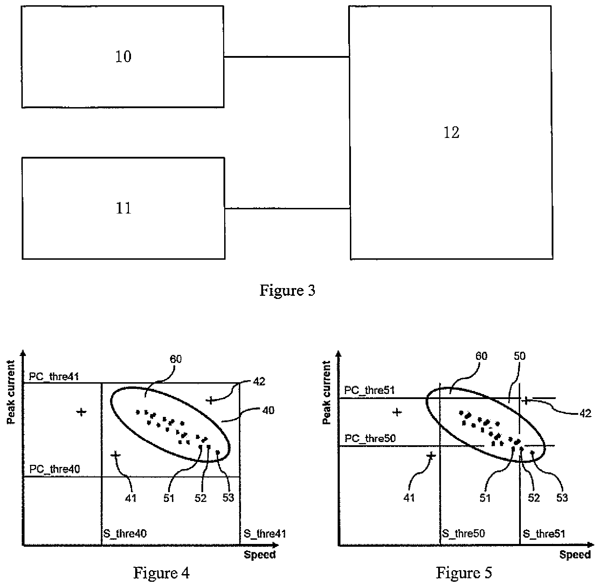

FIG.3 shows a system for monitoring a circuit according to an embodiment of present invention. Two of the operating condition related parameters, namely the opening/closing peak coil electric current of the circuit breaker and the opening/closing speed of a movable contact of the circuit breaker, are described thereafter for explaining the present invention. As shown in FIG. 3, the system 1 includes at least one sensor, for example a first sensor 10 and a second sensor 11 being configured to respectively measure a first operating condition related parameter and a second operating condition related parameter of the circuit breaker during operation of the circuit breaker. The skilled person should understand that two or more than two of the operating condition related parameters can be measured by one sensor. For example, those related to the movement of movable contact of the circuit breaker may be measured by the same encoder, including but not limited to the opening/closing speed of a movable contact of the circuit breaker, the travel of the movable contact, the total travel of the movable contact, the over travel of the movable contact, and rebound of the movable contact. In this embodiment, the first operating condition related parameter may be of the coil electric current of the circuit breaker; the first sensor 10 may use a hall sensor to measure AC current, producing an alternating current (AC) in its secondary which is proportional to the coil electric current of the circuit breaker in its primary, of which corresponding to the instance of circuit breaker opening/closing may be processed into the opening/closing peak coil electric current of the circuit breaker by the controller 12 of the system 1. The current transformer scales the large value of the coil electric current to small, standardized values that are easy to handle for the controller 12 of the system 1. It isolates measurement from the high voltage of the circuit breaker and presents a negligible load to the circuit breaker. Besides, the second operating condition related parameter may be of speed of the movable contact of the circuit breaker; the second sensor 11 may use a rotary encoder to provide information about the motion of the driving shaft 20, of which corresponding to the instance of circuit breaker opening/closing may be processed into information as speed by a controller 12 of the system 1. The input of the rotary encoder is mechanically coupled to the driving shaft 20, which converts the angular position or motion of the shaft to an analog or digital signal.

The skilled person should understand that the other operating condition related parameters, like the travel of the movable contact, the total travel of the movable contact, the over travel of the movable contact, the rebound of the movable contact, and the opening/closing time of the circuit breaker may be obtained through force sensor, hall sensor, and/or vibration sensor.

The first sensor 10 and the second sensor 11 may send data concerning the first operating condition related parameter and the second operating condition related parameter to the controller 12, thus from a state space point of view, the controller 12 may obtain a first data representing a vector having two components respectively representing the first operating condition related parameter and the second operating condition related parameter.

The controller 12 of the system 1 mainly provides for comparison processing of the first operating condition related parameter and the second operating condition related parameter of the circuit breaker detected by the first sensor 10 and the second sensor 11 with a healthy pattern. In addition, the data from the first sensor 10 and the second sensor 11 are considered so that the factors of circuit breaker's healthy status can be made by the final prognosis. The prognosis judgment is made based upon a knowledge data base and past diagnosis results stored in a memory 13 of the system 1.

FIG. 4 and FIG. 5 respectively show healthy vector space linearly defined by two threshold ranges concerning two types of operating condition related parameters. The graphs of FIG. 4 and FIG. 5 include an x-axis indicative of one of the components of the vector, namely the first operating condition related parameter, which, in this embodiment, corresponds to the opening/closing peak coil electric current of the circuit breaker; and an y-axis indicative of the other of the components of the vector, namely the second operating condition related parameter, which, in this embodiment, corresponds to the speed of the movable contact of the circuit breaker. Conventionally, by using linear analysis of the vectors from past diagnosis results, the vector spaces of the envelopes 40, 50 separating healthy and unhealthy status of the circuit breaker are shaped in rectangle. In particular considering FIG. 4, such area is bounded by x = S_thre40, x = S_thre41, y=PC_thre40, y=PC_thrd41, and for FIG. 5, such area is bounded by x = S_thre50, x = S_thre51, y=PC_thre50, y=PC_thrd51. The dots (vectors) presented in FIG. 4 and FIG. 5 illustrate the healthy pattern, where the circuit breaker operating with the first operating condition related parameter and the second operating condition related parameter as indicted by each of the dots is observed to be in healthy status extracted from a history profile. While according to the history profile, the crosses (vectors) presented in FIG. 4 and FIG. 5 give the unhealthy pattern, where the circuit breaker operating with the first operating condition related parameter and the second operating condition related parameter as indicted by each of the crosses is observed to be in unhealthy status.

As shown in FIG. 4, by applying the vector space defined by the envelope 40 for judging the healthy status of the circuit breaker, the crosses 41, 42 are located therein. Therefore, a circuit breaker in fact operates in an unhealthy status would be misjudged as healthy, causing a missed fault identification.

In order to overcome the defect of missed fault identification, the envelope 40 is shrinks horizontally and vertically, transforming into the envelope 50 as shown in FIG. 5. By applying the vector space defined by the envelope 50, the crosses 41, 42 would be excluded therefrom, however the dots 51, 52, 53 would stay outside of the envelope 50. Therefore, a circuit breaker in fact operates in a healthy status would be misjudged as unhealthy, causing a false alarm.

By analysis of the envelopes 40, 50 and the healthy pattern statistically, it can be observed that a healthy status of the circuit breaker hardly occurs in an area close to each of the four vertices. Thus, by cutting off the vertices of the envelope 40, 50 and supplementing with each cut-off with a curvature, both of the missed fault identification and the false alarm may be overcome. As shown in FIG. 4 and FIG. 5, in this embodiment, the newly adapted envelope 60 takes the form of an ellipse having at least one portion of curvature.

The controller 12 reads the knowledge data base and past diagnosis results stored in the memory 13 of the system 1, namely the history profile. From the history profile, the controller 12 may obtain a second data representing the envelope 60 of the vector space in consideration of a multiple of the vectors of the dots concerning the circuit breaker in healthy status when the circuit breaker operated normally. The envelope 60 of the vector space is arranged to enclose the group of the multiple of vectors (dots), which shall follow the healthy pattern with at least one portion of curvature. Then, the controller 12 may record the second data representing the vector space defined by the envelope 60 in the memory 13. In the vector space defined by the envelope 60, the envelope is shaped to link the outmost vectors of the multiple of the vectors.

By applying the envelope 60 separating healthy and unhealthy status of the circuit breaker, the controller 12 may give the judgement that the crosses 41, 42 are located outside of the vector space defined by the envelope 60, while the dots 51, 52, 53 are located inside thereof. Based on the judgement, the controller 12 may generate a signal indicating the health status of the circuit breaker in consideration of the location of the vector if it is outside of the envelope 60. In this embodiment for example, the controller 12 will give signal indicating a healthy status of the circuit in consideration of the situation where the dots are inside of the envelope 60, or a signal indicating an unhealthy status in consideration of the situation where the crosses are outside of the envelope 60. The present invention provides a highly sensitivity and highly accurate health prognosis system using a multiple of operating condition related parameter.

The above embodiment is exemplified with the vector space of two dimensions. The skilled person should understand that the vector space may be extended to more than two dimensions when considering the vector having more than two components. For example, the vector may include components involving any two or more of the operating condition of the circuit breaker:
a. opening/closing speed of a movable contact of the circuit breaker,
b. travel of the movable contact,
c. total travel of the movable contact,
d. over travel of the movable contact,
e. rebound of the movable contact,
f. opening/closing time of the circuit breaker, and
g. opening/closing peak coil electric current of the circuit breaker.

According to an embodiment of present invention, an internet of things includes the system for monitoring the circuit according to an embodiment of present invention, the circuit breaker, and a server being configured to receive the signal indicating the health status of the circuit breaker.

## Claims

1. A method for monitoring a circuit breaker, including
measuring at least two operating condition related parameters of the circuit breaker during operation of the circuit breaker;
obtaining first data representing a vector (51 - 53) having at least two components respectively representing the at least two measurements of the at least two operating condition related parameters;
judging location of the vector (51 - 53) represented by the obtained data with respect to a vector space having an envelope (60) separating healthy and unhealthy status of the circuit breaker based upon a knowledge or history data base, where the envelope (60) has at least one portion of curvature;
generating a signal indicating the health status of the circuit breaker in consideration of the location of the vector (51 - 53) if it is outside of the envelope (60); and
obtaining second data representing the envelope (60) of the vector space in consideration of a multiple of the vectors (51 - 53) concerning the circuit breaker in healthy status according to a history profile when the circuit breaker operated normally;
wherein: the envelope (60) of the vector space is arranged to enclose the group of the multiple of vectors (51 - 53);
wherein
in the vector space, the envelope (60) is shaped to link the outmost vectors (51 - 53) of the multiple of the vectors (51 - 53).

2. The method according to the previous claim, further including
recording the second data.

3. The method according to the previous claim, wherein the other portions of the envelope (60) are shaped in curvature.

4. The method according to any of the preceding claims, wherein the at least two operating condition related parameters of the circuit breaker concern with any at least two of: opening/closing speed of a movable contact of the circuit breaker, travel of the movable contact, total travel of the movable contact, over travel of the movable contact, rebound of the movable contact, opening/closing time of the circuit breaker, and opening/closing peak coil electric current of the circuit breaker.

5. A system for monitoring a circuit breaker, including
at least one sensor (10, 11), being configured to measure at least two operating condition related parameters of the circuit breaker during operation of the circuit breaker; and
a controller (12), being configured to
obtain first data representing a vector (51 - 53) having at least two components respectively representing the at least two measurements of the at least two operating condition related parameters;
judge location of the vector (51 - 53) represented by the obtained data with respect to a vector space having an envelope (60) separating healthy and unhealthy status of the circuit breaker based upon a knowledge or history data base, where the envelope (60) has at least one portion of curvature;
generate a signal indicating the health status of the circuit breaker in consideration of the location of the vector (51 - 53) if it is outside of the envelope (60); and
obtain second data representing the envelope (60) of the vector space in consideration of a multiple of the vectors (51 - 53) concerning the circuit breaker in healthy status according to a history profile when the circuit breaker operated normally; wherein: the envelope (60) of the vector space is arranged to enclose the group of the multiple of vectors (51 - 53);
wherein
in the vector space, the envelope (60) is shaped to link the outmost vectors (51 - 53) of the multiple of vectors (51 - 53).

6. The system according to the previous claim, further including
a memory (13); wherein
the controller (12) is further configured to:
record the second data in the memory (13).

7. The system according to the previous claim, wherein the other portions of the envelope (60) are shaped in curvature.

8. The system according to any of the three previous claims, wherein the at least two operating condition related parameters of the circuit breaker concern with any at least two of: opening/closing speed of a movable contact of the circuit breaker, travel of the movable contact, total travel of the movable contact, over travel of the movable contact, rebound of the movable contact, opening/closing time of the circuit breaker, and opening/closing peak coil electric current of the circuit breaker.

9. An internet of things, including
the system according to any of the four previous claims;
the circuit breaker; and
a server, being configured to receive the signal indicating the health status of the circuit breaker.

## Patentansprüche

1. Verfahren zum Überwachen eines Schutzschalters, beinhaltend
Messen von mindestens zwei mit Betriebsbedingungen im Zusammenhang stehenden Parametern des Schutzschalters während des Betriebs des Schutzschalters;
Erhalten von ersten Daten, die einen Vektor (51-53) mit mindestens zwei Komponenten darstellen, die jeweils die mindestens zwei Messungen der mindestens zwei mit Betriebsbedingungen im Zusammenhang stehenden Parameter darstellen:
Beurteilen der Position des Vektors (51-53), der durch die erhaltenen Daten dargestellt wird, in Bezug auf einen Vektorraum mit einer Hülle (60), der funktionierende und nichtfunktionierende Status des Schutzschalters trennt, auf Grundlage eines Wissens oder von Verlaufsdaten, wobei die Hülle (60) mindestens einen Krümmungsabschnitt aufweist;
Erzeugen eines Signals, das den Funktionsstatus des Schutzschalters unter Berücksichtigung der Position des Vektors (51-53) angibt, wenn er sich außerhalb der Hülle (60) befindet; und
Erhalten von zweiten Daten, die die Hülle (60) des Vektorraums unter Berücksichtigung einer Vielzahl der Vektoren (51-53) bezüglich des Schutzschalters im funktionierenden Status gemäß einem Verlaufsprofil darstellen, wenn der Schutzschalter normal arbeitet;
wobei: die Hülle (60) des Vektorraums so angeordnet ist, dass sie die Gruppe der Vielzahl von Vektoren (51-53) umschließt;
wobei
in dem Vektorraum die Hülle (60) so geformt ist, dass sie die äußersten Vektoren (51-53) der Vielzahl der Vektoren (51-53) verknüpft.

2. Verfahren nach dem vorhergehenden Anspruch, ferner beinhaltend Aufzeichnen der zweiten Daten.

3. Verfahren nach dem vorhergehenden Anspruch, wobei die anderen Abschnitte der Hülle (60) gekrümmt geformt sind.

4. Verfahren nach einem der vorhergehenden Ansprüche, wobei die mindestens zwei mit Betriebsbedingungen im Zusammenhang stehenden Parameter des Schutzschalters mindestens zwei von Folgendem betreffen: Öffnungs-/Schließgeschwindigkeit eines beweglichen Kontakts des Schutzschalters, Bewegung des beweglichen Kontakts, Gesamtbewegung des beweglichen Kontakts, übermäßiger Bewegung des beweglichen Kontakts, Rückprall des beweglichen Kontakts, Öffnungs-/Schließzeit des Schutzschalters und elektrischem Spitzenstrom der Spule beim Öffnen/Schließen des Schutzschalters.

5. System zum Überwachen eines Schutzschalters, beinhaltend
mindestens einen Sensor (10, 11), der dazu konfiguriert ist, mindestens zwei mit Betriebsbedingungen im Zusammenhang stehende Parameter des Schutzschalters während des Betriebs des Schutzschalters zu messen; und
ein Steuerelement (12), das zu Folgendem konfiguriert ist:
Erhalten von ersten Daten, die einen Vektor (51-53) mit mindestens zwei Komponenten darstellen, die jeweils die mindestens zwei Messungen der mindestens zwei mit Betriebsbedingungen im Zusammenhang stehenden Parameter darstellen:
Beurteilen der Position des Vektors (51-53), der durch die erhaltenen Daten dargestellt wird, in Bezug auf einen Vektorraum mit einer Hülle (60), der funktionierende und nichtfunktionierende Status des Schutzschalters trennt, auf Grundlage eines Wissens oder von Verlaufsdaten, wobei die Hülle (60) mindestens einen Krümmungsabschnitt aufweist;
Erzeugen eines Signals, das den Funktionsstatus des Schutzschalters unter Berücksichtigung der Position des Vektors (51-53) angibt, wenn er sich außerhalb der Hülle (60) befindet; und
Erhalten von zweiten Daten, die die Hülle (60) des Vektorraums unter Berücksichtigung einer Vielzahl der Vektoren (51-53) bezüglich des Schutzschalters im funktionierenden Status gemäß einem Verlaufsprofil darstellen, wenn der Schutzschalter normal arbeitet;
wobei: die Hülle (60) des Vektorraums so angeordnet ist, dass sie die Gruppe der Vielzahl von Vektoren (51-53) umschließt;
wobei
in dem Vektorraum die Hülle (60) so geformt ist, dass sie die äußersten Vektoren (51-53) der Vielzahl von Vektoren (51-53) verknüpft.

6. System nach dem vorhergehenden Anspruch, ferner beinhaltend
einen Speicher (13); wobei
das Steuerelement (12) ferner zu Folgendem konfiguriert ist:
Aufzeichnen der zweiten Daten in dem Speicher (13)

7. Verfahren nach dem vorhergehenden Anspruch, wobei die anderen Abschnitte der Hülle (60) gekrümmt geformt sind.

8. System nach einem der drei vorhergehenden Ansprüche, wobei die mindestens zwei mit Betriebsbedingungen im Zusammenhang stehenden Parameter des Schutzschalters mindestens zwei von Folgendem betreffen: Öffnungs-/Schließgeschwindigkeit eines beweglichen Kontakts des Schutzschalters, Bewegung des beweglichen Kontakts, Gesamtbewegung des beweglichen Kontakts, übermäßiger Bewegung des beweglichen Kontakts, Rückprall des beweglichen Kontakts, Öffnungs-/Schließzeit des Schutzschalters und elektrischem Spitzenstrom der Spule beim Öffnen/Schließen des Schutzschalters.

9. Internet der Dinge, beinhaltend
das System nach einem der vier vorhergehenden Ansprüche;
den Schutzschalter; und
einen Server, der dazu konfiguriert ist, das Signal zu empfangen, das den Funktionsstatus des Schutzschalters angibt.

## Revendications

1. Procédé de surveillance d'un disjoncteur, incluant les étapes consistant à
mesurer au moins deux paramètres liés à une condition de fonctionnement du disjoncteur pendant le fonctionnement du disjoncteur ;
obtenir des premières données représentant un vecteur (51 à 53) ayant au moins deux composantes représentant respectivement les au moins deux mesures des au moins deux paramètres liés à une condition de fonctionnement :
juger de la position du vecteur (51 à 53) représenté par les données obtenues par rapport à un espace vectoriel ayant une enveloppe (60) séparant le statut sain du statut défectueux du disjoncteur en se basant sur une base de données de connaissances ou d'historique, où l'enveloppe (60) a au moins une partie de courbure ;
générer un signal indiquant le statut de santé du disjoncteur en prenant en compte la position du vecteur (51 à 53) s'il est à l'extérieur de l'enveloppe (60) ; et
obtenir des secondes données représentant l'enveloppe (60) de l'espace vectoriel en prenant en compte un multiple des vecteurs (51 à 53) concernant le disjoncteur dans un statut sain selon un profil d'historique lorsque le disjoncteur fonctionnait normalement ;
dans lequel : l'enveloppe (60) de l'espace vectoriel est agencée pour renfermer le groupe du multiple de vecteurs (51 à 53) ;
dans lequel
dans l'espace vectoriel, l'enveloppe (60) est formée de sorte à relier les vecteurs (51 à 53) les plus externes du multiple des vecteurs (51 à 53).

2. Procédé selon la revendication précédente, incluant en outre une étape consistant à enregistrer les secondes données.

3. Procédé selon la revendication précédente, dans lequel les autres parties de l'enveloppe (60) sont mises en forme selon une courbure.

4. Procédé selon l'une quelconque des revendications précédentes, dans lequel les au moins deux paramètres liés à une condition de fonctionnement du disjoncteur concernent au moins deux parmi : une vitesse d'ouverture/fermeture d'un contact mobile du disjoncteur, un trajet du contact mobile, un trajet total du contact mobile, un trajet excessif du contact mobile, un rebond du contact mobile, un temps d'ouverture/fermeture du disjoncteur, et un courant électrique de bobine de pic d'ouverture/fermeture du disjoncteur.

5. Système de surveillance d'un disjoncteur, incluant
au moins un capteur (10, 11), configuré pour mesurer au moins deux paramètres liés à une condition de fonctionnement du disjoncteur pendant le fonctionnement du disjoncteur ; et
un dispositif de commande (12), configuré pour
obtenir des premières données représentant un vecteur (51 à 53) ayant au moins deux composantes représentant respectivement les au moins deux mesures des au moins deux paramètres liés à une condition de fonctionnement :
juger de la position du vecteur (51 à 53) représenté par les données obtenues par rapport à un espace vectoriel ayant une enveloppe (60) séparant le statut sain du statut défectueux du disjoncteur en se basant sur une base de données de connaissances ou d'historique, où l'enveloppe (60) a au moins une partie de courbure ;
générer un signal indiquant le statut de santé du disjoncteur en prenant en compte la position du vecteur (51 à 53) s'il est à l'extérieur de l'enveloppe (60) ; et
obtenir des secondes données représentant l'enveloppe (60) de l'espace vectoriel en prenant en compte un multiple des vecteurs (51 à 53) concernant le disjoncteur dans un statut sain selon un profil d'historique lorsque le disjoncteur fonctionnait normalement ;
dans lequel : l'enveloppe (60) de l'espace vectoriel est agencée pour renfermer le groupe du multiple de vecteurs (51 à 53) ;
dans lequel
dans l'espace vectoriel, l'enveloppe (60) est formée de sorte à relier les vecteurs (51 à 53) les plus externes du multiple des vecteurs (51 à 53).

6. Système selon la revendication précédente, incluant en outre
une mémoire (13) ; dans lequel
le dispositif de commande (12) est en outre configuré pour :
enregistrer les secondes données dans la mémoire (13).

7. Système selon la revendication précédente, dans lequel les autres parties de l'enveloppe (60) sont mises en forme selon une courbure.

8. Système selon l'une quelconque des trois revendications précédentes, dans lequel les au moins deux paramètres liés à une condition de fonctionnement du disjoncteur concernent au moins deux parmi : une vitesse d'ouverture/fermeture d'un contact mobile du disjoncteur, un trajet du contact mobile, un trajet total du contact mobile, un trajet excessif du contact mobile, un rebond du contact mobile, un temps d'ouverture/fermeture du disjoncteur, et un courant électrique de bobine de pic d'ouverture/fermeture du disjoncteur.

9. Internet des objets, incluant
le système selon l'une quelconque des quatre revendications précédentes ;
le disjoncteur ; et
un serveur, configuré pour recevoir le signal indiquant le statut de santé du disjoncteur.
